(19) Europäisches Patentamt / European Patent Office / Office européen des brevets

(11) **EP 2 700 083 B1**

(12) **EUROPÄISCHE PATENTSCHRIFT**

(45) Veröffentlichungstag und Bekanntmachung des Hinweises auf die Patenterteilung:
**22.04.2015 Patentblatt 2015/17**

(21) Anmeldenummer: **12720091.3**

(22) Anmeldetag: **04.04.2012**

(51) Int Cl.:
*H01J 37/34* (2006.01)   *C23C 14/34* (2006.01)

(86) Internationale Anmeldenummer:
**PCT/EP2012/001484**

(87) Internationale Veröffentlichungsnummer:
**WO 2012/143091 (26.10.2012 Gazette 2012/43)**

(54) **VERFAHREN ZUR BEREISTELLUNG SEQUENZIELLER LEISTUNGSPULSE**

METHOD FOR SUPPLYING SEQUENTIAL POWER IMPULSES

PROCÉDÉ PERMETTANT DE FOURNIR DES IMPULSIONS DE PUISSANCE SÉQUENTIELLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.04.2011 DE 102011018363**
**28.10.2011 DE 102011117177**

(43) Veröffentlichungstag der Anmeldung:
**26.02.2014 Patentblatt 2014/09**

(73) Patentinhaber: **Oerlikon Surface Solutions AG, Trübbach**
**9477 Trübbach (CH)**

(72) Erfinder:
• **KRASSNITZER, Siegfried**
**CH-6800 Feldkirch (CH)**
• **LENDI, Daniel**
**CH-9472 Grabs (CH)**
• **LECHTHALER, Markus**
**39100 Bozen (IT)**
• **RUHM, Kurt**
**9486 Schaanwald (LI)**

(74) Vertreter: **Kempkens, Anke**
**Hofgraben 486**
**86899 Landsberg (DE)**

(56) Entgegenhaltungen:
**WO-A2-2009/132822       DE-A1-102006 017 382**
**DE-U1-202010 001 497**

EP 2 700 083 B1

**Beschreibung**

Die vorliegende Erfindung bezieht sich auf ein Verfahren zur Erzeugung von Leistungspulsen.

Solche Leistungspulse werden beispielsweise im Rahmen der HIPIMS-Technologie benötigt. HIPIMS steht für High Power Impulse Magnetron Sputtering. Dabei handelt es sich um ein Vakuumbeschichtungsverfahren bei dem mittels sehr hoher Entladungsströme Material von einer Kathode zerstäubt wird, wodurch garantiert ist, dass das zerstäubte Material hochgradig positiv ionisiert wird. Wird gleichzeitig an die zu beschichtenden Substrate eine negative Spannung angelegt, so hat dies zur Folge, dass die durch die Zerstäubung entstandenen positiven Ionen in Richtung Substrate beschleunigt werden und somit zum Aufbau einer dichten Schicht führen. Es kommen dabei Leistungen von z.B. 40kW und mehr zum Einsatz. Allerdings ist es nur im Rahmen eines kurzen Leistungspulses möglich von der Kathode Material zu zerstäuben, da diese bei längerer Leitungseinwirkung durch Überhitzung Schaden nehmen kann. Die Dauer während der von einer Kathode mit hoher Leistung zerstäubt werden kann muss somit begrenzt werden, was zu einer maximal zulässigen Pulsdauer führt.

Ein Ansatz, dies zu verwirklichen besteht darin, die ganze Kathode in Teilkathoden aufzuteilen und Leistung sequenziell nacheinander auf die Teilkathoden zu bringen. Mit diesem Konzept ist gemeint, dass mehrere voneinander isolierte Kathoden (hier Teilkathoden genannt) in der Beschichtungsanlage vorgesehen sind, so dass es lokal beschränkt zu einem hohen Entladungsstrom kommen kann. Eine mögliche Realisierung dieses Ansatzes ist in der Deutschen Patentanmeldung DE102011018363 beschrieben.

Während eines auf eine Teilkathode einwirkenden Leistungspulses wird von dieser Kathode mit hoher Entladungsstromdichte zerstäubt. Gleichzeitig kann oder können der oder die anderen Teilkathoden abkühlen bevor erneut ein Leistungspuls auf sie einwirkt.

In der Patentschrift DE102006017382 A1 wird ein Verfahren und eine Vorrichtung zum Beschichten von Oberflaächen mittels HIPIMS offenbart, bei dem mehrere Kathode sequentiell von einer Leistungsversorgung gepulst werden.

Die Erfinder haben allerdings festgestellt, dass die Pulsdauer selbst einen hohen Einfluss auf die Schichteigenschaften der mittels Magnetronzerstäuben aufgebauten Schicht hat. Es werden daher Generatoren benötigt welche in der Lage sind, sowohl sehr kurze als auch relativ lange andauernde hohe Leistungspulse abzugeben..

Generatoren liefern in der Regel zuverlässig eine konstante Spannung bei konstantem Strom. Im Englischen werden sie "power supply" genannt, was übersetzt so viel wie Leistungsversorgung bedeutet. Anspruchsvoll wird die Situation, wenn es wie oben beschrieben darum geht kurze Leistungspulse hoher Leistung zu erzeugen. Beim Anschalten der Leistungsversorgung welche ein Leistung von z.B. 40kW abgeben soll vergehen bis zur vollständigen Leistungsabgabe mit den handelsüblichen Spannungsquellen grössenordnungsmässig ca. $700\mu$s. Werden, wie vorliegend, Leistungspulse mit kürzerer Pulsdauer benötigt, so ist die zur Verfügung stehende Zeit bereits vor vollständiger Leistungsausbau abgelaufen. Das Leistungsprofil solcher Pulse ist entsprechend unkontrolliert dynamisch und das darauf aufbauende Zerstäubungsverfahren führt zu schlecht reproduzierbaren und in ihren Eigenschaften suboptimalen Schichten.

Mit dem vorliegenden erfindungsgemässen Verfahren soll daher eine Möglichkeit angegeben werden, in einfacher Weise zu Leistungspulsen mit definiertem Profil zu gelangen wobei die Dauer der Leistungspulse in einfacher Weise über weite Intervalle skalierbar sein sollte.

Erfindungsgemäss wird die Aufgabe dadurch gelöst, dass die einer ersten Teilkathode zugeordneten Leistungspulsintervalle mit den einer zweiten Teilkathode zugeordneten Leistungspulsintervalle geringfügig zeitlich überlappen dergestalt, dass beim Umleiten der Leistung von der ersten Teilkathode auf die zweite Teilkathode der die Leistung liefernde Generator nicht ausgeschaltet werden muss sondern die Leistungsentnahme vom Generator ununterbrochen stattfindet und es somit nicht zu einem erneuten Leistungsaufbau kommen muss. Während der Zeit der Überlappung der beiden Leistungspulsintervalle brennt das Plasma lediglich bei der ersten Teilkathode da die diesbezügliche Impedanz gegenüber der Impedanz der noch nicht gezündeten zweiten Teilkathode deutlich niedriger ist. Erst wenn am Ende des ersten Leistungspulsintervall die erste Teilkathode vom Generator getrennt wird zündet das Plasma an der zweiten Teilkathode, dies jedoch so schnell, dass es zu einer im Wesentlichen kontinuierlichen Leistungsentnehme vom Generator kommt. Liegt eine dritte Teilkathode vor, so wird dafür gesorgt, dass das der dritten Teilkathode zugeordnete Leistungspulsintervall mit dem der zweiten Teilkathode zugeordneten Leistungspulsintervall geringfügig überlappt, so dass wiederum beim Umleiten der Leistung von der zweiten Teilkathode auf die dritte Teilkathode nicht zu einen Unterbruch der Leistungsentnahme kommt. Allgemein ausgedrückt wird dafür gesorgt dass das der nten Teilkathode zugeordnete Leistungspulsintervall mit dem der (n-1)ten Teilkathode zugeordneten Leistungspulsintervall geringfügig überlappt, wodurch beim Umleiten der Leistung von der (n-1)ten Teilkathode auf die nte Teilkathode ein Unterbruch der Leistungsentnahme vom Generator vermieden wird. Erst wenn die Leistung auf die letzte Teilkathode umgeleitet wurde und der dieser letzten Teilkathode zugeordnete Leistungspuls abgegeben wurde, d.h. wenn ein Leistungspulszyklus - im Folgenden auch Gruppe genannt - vollendet ist, wird die Leistungsentnahme vom Generator unterbrochen. Die sich anschliessende Leistungspause wird dazu genutzt die Teilkathoden abzukühlen, bevor es erneut die erste Teilkathode mit dem ihr zugeordnetem Leistungspuls im entsprechenden Intervall beaufschlagt wird.

Ein solches Vorgehen führt allerdings dazu, dass zumindest der an der ersten Teilkathode abgegebene Leistungspuls im zeitlichen Bereich des Leistungsaufbaus des Generators liegt und der entsprechende Leistungspuls ein dementsprechend unerwünschtes Profil aufweist. Gemäss einer bevorzugten Ausführungsform der vorliegenden Erfindung wird daher vorgängig zur Beaufschlagung der ersten Teilkathode mit Leistung für zumindest näherungsweise das Leistungsaufbauintervall eine sogenannte Dummy-Kathode mit Leistung beaufschlagt. Es wird dann dafür gesorgt, dass das der ersten Teilkathode zugeordnete Leistungspulsintervall geringfügig mit dem Leistungsaufbauintervall überlappt, woduch beim Umleiten von der Dummy-Kathode auf die erste Teilkathode ein Unterbruch der Leistungsentnahme vom Generator vermieden wird und im Rahmen des ersten Leistungspulsintervalls im Wesentlichen bereits die volle Leistung zur Verfügung steht. Die oben erwähnte Dummy-Kathode kann beispielsweise mit einem Stromkreis mit ohmschem Widerstand verwirklicht werden, an dem die entsprechende Spannung abfällt und die Leistung somit in Wärme umgesetzt wird.

Wie zuvor erwähnt kann das Leistungsaufbauintervall durchaus in der Grössenordnung um die $700\mu s$ liegen. Die während dieses Intervalls vom Generator am die Dummy-Kathode abgegebene Leistung kommt dem Beschichtungsprozess nicht zugute, geht also verloren und stellt einen Verlust dar. Dies ist dann unproblematisch wenn der Leistungspulszyklus, also das Gruppenintervall gross gegenüber dem Leistungsaufbauintervall ist und somit der Leistungsverlust lediglich einen kleinen Prozentsatz ausmacht. Dies ist allerdings problematisch, wenn die Leistungsimpulsintervalle so klein werden, dass das Leistungsaufbauintervall im Vergleich zum Gruppenintervall durchaus relevant wird. In einem solchen Fall kommt es zu einem signifikanten und damit inakzeptablen Leistungsverlust.

Dies kann mit einer weiteren bevorzugten Ausführungsform der vorliegenden Erfindung vermieden werden. Die Erfinder haben nämlich erkannt, dass gerade bei kurzen Leistungspulsintervallen ein abkühlen der Teilkathoden noch gar nicht notwendig ist. In diesem Fall wird an den ersten Leistungspulszyklus ein zweiter Leistungspulszyklus angeschlossen. Dabei wird dafür gesorgt, dass das erste Leistungspulsintervall des zweiten Leistungspulszyklus (d.h. der zweiten Gruppe) geringfügig mit dem letzten Leistungspulsintervall des ersten Leistungspulszyklus der ersten Gruppe überlappt, so dass ein Umleiten der Leistung von der letzten Teilkathode auf die erste Teilkathode ohne Unterbruch der Leistungsentnahme vom Generator möglich ist. Auf diese Weise wird für die zweite Gruppe ein Leistungsaufbauintervall und der mit dem Abführen der Leistung auf die Dummy-Kathode einhergehende Leistungsverlust vermieden. Es ist möglich, auf entsprechende Weise so viele Gruppen aneinander zu reihen, bis aufgrund der bei den Teilkathoden auftretenden Wärmeentwicklung ein tatsächlicher Unterbruch der Leistungszuführung stattfinden muss oder sollte. In einem solchen Gruppenzug wird es lediglich einmal zu Anfang des Zuges notwendig sein, die Leistung während des Leistingsaufbauintervalls auf die Dummy-Kathode zu leiten.

Die Erfindung wird nun im Detail und anhand von Schemata beispielhaft anhand der Zertstäubungstechnologie (Sputtertechnologie) erläutert.

Es werden folgende Abkürzungen bei den nachfolgenden Beispielen verwendet:

| | |
|---|---|
| Pavg | mittlere Sputterleistung |
| Pmax | maximale Sputterleistung (Pulse Power) |
| tpn | Pulslänge |
| tdn | Pulsverzögerung |
| N | Anzahl der Gruppen (N = 0 ...500) |
| n | Kanalnummer (=Anzahl Teilkathoden, n = 0 ....6, n=0 entspricht Dummy-Kathode) |
| fr | Wiederholfrequenz |
| tr | Wiederholdauer = 1/fr |

Um eine Kathodenüberhitzung zu vermeiden wird angenommen dass innerhalb eines Leistungszuges auf Gesamtzeit während der auf eine Teilkathode Leistung aufgebracht werden kleiner als 100ms sein muss:

$$(tpn\text{-}tdn)*N < 100ms = Tmax$$

1. Beispiel

Im Rahmen des ersten Beispiels wird die Dummy-Kathode für 0.5ms mit Leistung beaufschlagt, d.h. das Verlustintervall tp0 beträgt 0.5ms und umfasst damit sicherlich das Leistungsaufbauintervall von ca. 0.25ms. Zusätzlich zur Dummy-Kathode werden 6 Teilkathoden verwendet. Die Leistungspulsintervalle während der in einer Gruppe Leistung auf eine Teilkathode aufgebracht wird, werden auf tp1-6 = 0.2ms festgelegt und der

Überlapp der Leistungspulsintervalle wird auf td1-6 = 0.02ms festgelegt. Es werden insgesamt 10 Leistungspulszyklen gefahren, d.h. 10 Gruppen bilden zusammen mit dem Verlustintervall einen Zug. Damit dauert die Gesamtzugintervall 10*6*(0.2ms-0.02ms)+0.5ms = 10.8ms+0.5ms =11.3ms.

Damit steht ein Verlustintervall von 0.5ms einer für die Beschichtungszwecke verwendeten Zeit für Leistungsabgabe von 10.8ms gegenüber. Im Vergleich zu dem Leistungsverlust an der Dummy-Kathode wird also mehr als 20 mal soviel Leistung für Beschichtungszwecke einesetzt.

Liegen nun während des Leistungspulsintervalls 40kW an einer Teilkathode und ist eine mittlere Sputterleistung von 5kW an jeder Teilkathode vorgegeben, so sollte das Gesamtzugintervall mit einer Frequenz von 69.4Hz wiederholt werden, weil gilt:

$$(tpn-tdn)*N*Pmax*fr=0.18ms*10*40kW*69.4Hz = 5kW.$$

Dem steht an der Dummy-Kathode ein mittlerer Leistungsverlust von maximal 0.5ms*40kW*69.4Hz=1.39kW gegenüber. Eine Wiederholfrequenz von 69.4Hz entspricht einer Wiederholdauer von 14.4ms. Bei einer Dauer des Gesamtzugintervalls von 11.3ms bedeutet dies, dass zwischen den Zügen eine Pause von 3.1 ms eingelegt werden sollte.

2. Beispiel

Im Rahmen des zweiten Beispiels wird das Leistungspulsintervall auf 0.07ms reduziert und die Anzahl der Gruppen auf 100 erhöht. Die anderen Parameter werden beibehalten. Damit dauert das Gesamtzugintervall 100*6*(0.07ms-0.02ms)+0.5ms=30ms+0.5ms=30.5ms.

Damit steht ein Verlustintervall von 0.5ms einer für die Beschichtungszwecke verwendeten Zeit für Leistungsabgabe von 30ms gegenüber. Im Vergleich zu dem Leistungsverlust an der Dummy-Kathode wird also mehr als 60 mal soviel Leistung für Beschichtungszwecke eingesetzt.

Liegen nun während des Leistungspulsintervalls 40kW an einer Teilkathode und ist eine mittlere Sputterleistung von 5kW an jeder Teilkathode vorgegeben, so sollte Gesamtzugintervall mit einer Frequenz von 25Hz wiederholt werden, weil gilt:

$$(tpn-tdn)*N*Pmax*fr=0.05ms*100*40kW*25Hz = 5kW$$

Dem steht ein mittlerer Leistungsverlust an der Dummy-Kathode von maximal 0.5ms*40kW*25Hz=0.5kW gegenüber. Die Wiederholfrequenz von 25Hz entspricht einer Wiederholdauer von 40ms. Bei einer Dauer des Gesamtzugintervalls von 30.5ms bedeutet dies, dass eine Pause von 9.5ms zwischen zwei Zügen eingelegt werden sollte.

3. Beispiel

Im Rahmen des dritten Beispiels wird das Leistungspulsintervall auf 0.05ms reduziert und die Anzahl der Gruppen auf 1000 erhöht. Die anderen Parameter werden beibehalten. Damit dauert das Gesamtzugintervall 1000*6*(0.05ms-0.02ms)+0.5ms=180ms+0.5ms=180.5ms.

Dait steht ein Verlustintervall von 0.5ms einer für die Beschichtungszwecke verwendeten Zeit für Leistungsabgabe von 180ms gegenüber. Im Vergleich zu dem Leistungsverlust an der Dummy-Kathode wird also mehr als 360 mal soviel Leistung für Beschichtungszwecke eingesetzt.

Liegen nun während des Leistungspulsintervalls 60kW an einer Teilkathode und ist eine mittlere Sputterleistung von ca. 5kW an jeder Teilkathode vorgegeben, so sollte das Gesamtzugintervall mit einer Frequenz von 2.7Hz wiederholt werden, weil gilt:

$$(tpn-tdn)*N*Pmax*fr=0.03ms*1000*60kW*2.7Hz = 4.86kW$$

Dem steht ein mittlerer Leistungsverlust an der Dummy-Kathode von maximal 0.5ms*60kW*2.7Hz=81W gegenüber. Die Wiederholfrequenz von 2.7Hz entspricht einer Wiederholdauer von 360ms. Bei einer Dauer des Gesamtzugintervalls von 180.5ms bedeutet dies, dass eine Pause von 179.5ms zwischen zwei Zügen eingelegt werden sollte.

4. Beispiel

Im Rahmen des vierten Beispiels wird das Leistungspulsintervall mit 0.05ms und die Anzahl der Gruppen mit 1000 beibehalten, ebenso die anderen Parameter. Damit dauert das Gesamtzugintervall 1000*6*(0.05ms-0.02ms)+0.5ms=180ms+0.5ms=180.5ms.

Damit steht ein Verlustintervall von 0.5ms einer für die Beschichtungszwecke verwendeten Zeit für Leistungsabgabe von 180ms gegenüber. Im Vergleich zu dem Leistungsverlust an der Dummy-Kathode wird also mehr als 360 mal soviel Leistung für Beschichtungszwecke eingesetzt.

Liegen nun während des Leistungspulsintervalls nicht mehr 60kW wie im Beispiel 3, sondern lediglich 33kW an einer Teilkathode und ist eine mittlere Sputterleistung von ca. 5kW an jeder Teilkathode vorgegeben, so sollte das Gesamtzugintervall mit einer Frequenz von 5.05Hz wiederholt werden, weil gilt:

$$(tpn-tdn)*N$$

$$*Pmax*fr=0.03ms*1000*33kW*5.05Hz = 5kW$$

Dem steht ein mittlerer Leistungsverlust an der Dummy-Kathode von maximal 0.5ms*33kW*5.05Hz=83W gegenüber. Die Wiederholfrequenz von 5.05Hz entspricht einer Wiederholdauer von 198ms. Bei einer Dauer des Gesamtzugintervalls von 180.5ms bedeutet dies, dass eine Pause von lediglich 17.5ms zwischen zwei Zügen eingelegt werden sollte.

Wie die oben skizzierten Beispiele zeigen erlaubt das erfindungsgemässe Verfahren eine einfache Skalierung der Pulsdauer, Pulshöhe, Pulswiederholfrequenz sowie der genauen Definition des Pulsprofiles bei einer nahezu verschwindend geringen Verlustleistung. All diese Grössen, die unter dem Stichwort skalierbare Pulscharakteristik zusammengefasst werden können, haben beim Sputtern und insbesondere im Rahmen der HIPIMS-Techologie direkten Einfluss auf die Eigenschaften der dabei entstehenden Schichten. Obwohl die Beschreibung die Erfindung die Bereitstellung von Leistungspulsen im Rahmen der Sputtertechnologie darstellt ist sie überall dort vorteilhaft anwendbar, wo eine vergleichsweise hohe Leistung im Rahmen von Pulsen auf eine Last aufgebracht werden muss.

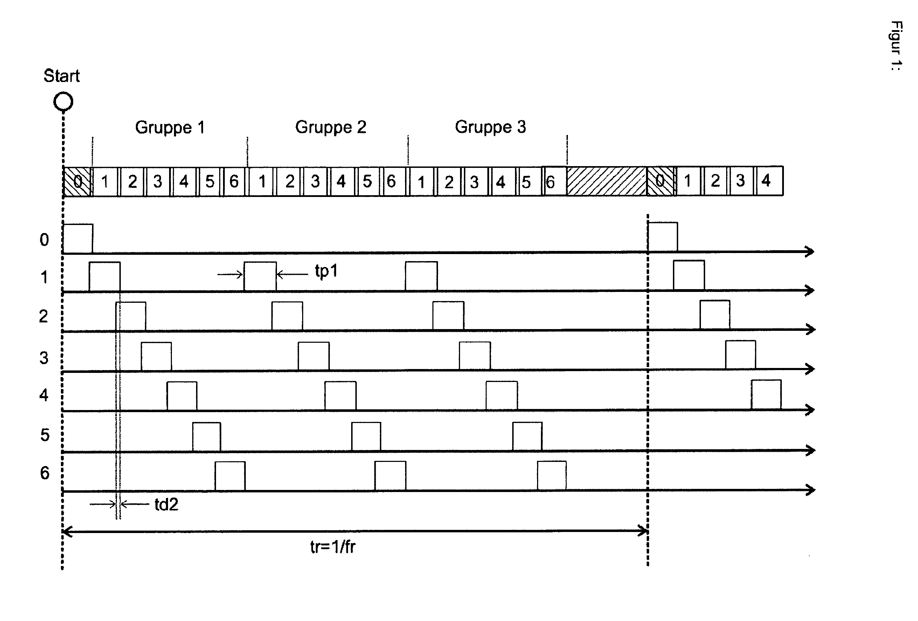

Die Figur 1 zeigt die den Beispielen entsprechende Situation sowohl als einheitlicher Zug als auch aufgesplittet in das Verlustintervall (0) und die Leistungspulsintervalle an den Teilkathoden (1-6). Dabei stellt die horizontale Achse die Zeitachse dar und die Vertikale Achse entspricht der vom Generator abgegebenen Leistung, wobei in den Bereichen des Überlapps (z.B. td1) die Leistung zwischen zwei Lasten aufgeteilt werden muss, was in der Figur nicht gezeigt ist. Allerdings sind in der Figur lediglich 3 Gruppen gezeigt.

**Patentansprüche**

**1.** Verfahren zur Bereitstellung von Leistungspulsen mit skalierbarem Leistungspulsintervall zum Betreiben einer PVD-Zerstäubungskathode die PVD-Zerstäubungskathode eine erste Teilkathode und eine zweite Teilkathode umfasst, wobei für die Teilkathoden eine maximale mittlere Leistungsbeaufschlagung vorgegeben ist und wobei die Dauer der Leistungspulsintervalle vorgegeben werden und das Verfahren folgende Schritte umfasst

a) Bereitstellen eines Generators mit vorgegebener vorzugsweise zumindest nach Anschalten und nach Ablauf eines Leistungsaufbauintervalls konstanter Leistungsabgabe
b) Anschalten des Generators
c) Anschluss der ersten Teilkathode an den Generator, so dass die erste Teilkathode mit Leistung vom Generator beaufschlagt wird
d) Trennung des Generators von der ersten Teilkathode nach Ablauf eines vorgegebenen der ersten Teilkathode entsprechenden ersten Leistungspulsintervalls
e) Anschluss der zweiten Teilkathode an den Generator so dass die zweite Teilkathode mit Leistung vom Generator beaufschlagt wird
f) Trennung des Generators von der zweiten Teilkathode nach Ablauf eines vorgegebenen der zweiten Teilkathode entsprechenden zweiten Leistungspulsintervalls

wobei das erste Leistungspulsintervall zeitlich vor dem zweiten Leistungspulsintervall beginnt und das erste Leistungspulsintervall zeitlich vor dem zweiten Leistungspulsintervall endet,

**dadurch gekennzeichnet dass** die Schritte d) und e) so ausgeführt werden dass sich erstes Leistungspulsintervall und zweites Leistungspulsintervall zeitlich überlappen und alle Leistungspulsintervalle zusammen eine erste Gruppe bilden, so dass die Leistungsabgabe vom Generator durchgehend ohne Unterbrechung vom Anfang des ersten Leistungspulsintervalls bis zum Ende des zweiten Leistungspulsintervalls bestehen bleibt und es nicht zu einem zweiten Leistungsaufbauintervall kommt.

2. Verfahren nach Anspruch 1, **dadurch gekennzeichnet dass** die zeitliche Überlappung des ersten Leistungspulsintervalls und des zweiten Leistungspulsintervalls nicht mehr als x% der Leistungspulsintervalle bzw. falls erstes Leistungspulsintervall sich vom zweiten Leistungspulsintervall in der Dauer unterscheidet, nicht mehr als x% des Leistungspulsintervalls kürzerer Dauer beträgt, wobei x kleiner gleich 20, vorzugsweise x kleiner gleich 10 ist.

3. Verfahren nach Ansprüchen 1 oder 2, **dadurch gekennzeichnet, dass** die PVD-Zerstäubungskathode zumindest eine weitere Teilkathode, bevorzugt mehrerer weitere Teilkathoden umfasst, wobei die weitere Teilkathode entsprechend der Schritte e) und f) an den Generator angeschlossen und von ihm getrennt werden wobei das jeweils der an die Reihe kommenden weiteren Teilkathode zugeordneten Leistungspulsintervalle mit dem Leistungspulsintervall welches der unmittelbar zuvor an die Reihe gekommenen Teilkathode entspricht zeitlich überlappt und erstes, zweites und das oder die weiteren Leistungspulsintervalle zusammen die zeitlich ununterbrochene erste Gruppe bilden, so dass die Leistungsabgabe vom Generator während des durch die erste Gruppe gebildeten Guppenintervalls durchgehend ohne Unterbrechung bestehen bleibt und es nicht zu einem zweiten Leistungsaufbauintervall kommt.

4. Verfahren nach einem der vorangehenden Ansprüche, **dadurch gekennzeichnet, dass** an die erste Gruppe eine zweite Gruppe angehängt wird innerhalb derer der ersten Gruppe entsprechend die erste, zweite und gegebenenfalls die weiteren Teilkathoden mit Leistungspulsen innerhalb sich überlappender Leistungspulsintervallen beaufschlagt werden, wobei die zweite Gruppe so an die erste Gruppe angehängt wird, dass das erste Leistungspulsintervall der zweiten Gruppe mit dem letzten Leistungspulsintervall der ersten Gruppe überlappt, so dass die Leistungsabgabe vom Generator vom Anfang des ersten Leistungsintervalls der ersten Gruppe bis zum Ende des letzten Leistungsintervalls der zweiten Gruppe durchgehend ohne Unterbrechung bleibt und es nicht zu einem zweiten Leistungsaufbauintervall kommt

5. Verfahren nach Anspruch 4 **dadurch gekennzeichnet, dass** entsprechend der in Anspruch 4 für Gruppe 1 und 2 formulierten Bedingungen N Gruppen aneinander angehängt werden, wobei N eine ganze Zahl >1 ist.

6. Verfahren nach Anspruch 5 **dadurch gekennzeichnet, dass** die Zahl N der Gruppen vorzugsweise maximal jedoch nur so gross gewählt wird, dass für jede Teilkathode n gilt, dass die Summe der ihr zugeordneten Leistungspulsintervalle tpn abzüglich jeweils einer Überlappung tdn über alle Gruppen 1 bis N eine maximale Zeit von 100ms nicht überschreitet.

7. Verfahren nach einem der vorangehenden Ansprüche, **dadurch gekennzeichnet, dass** während eines Verlustintervalls, die vom Generator abgegebene Leistung an eine nicht für die Beschichtung genutzte Last abgegeben wird, wobei das Verlustintervall das Leistungsaufbauintervall zumindest umfasst und das Verlustintervall mit dem ersten Leistungspulsintervall der ersten Gruppe überlappt und das Verlustintervall zusammen mit den Gruppen einen ununterbrochenen Zug bilden.

8. Verfahren nach einem der vorangehenden Ansprüche, **dadurch gekennzeichnet, dass** Verfahren gemäss einem der Ansprüche vielfach wiederholt wird und das jeweils nach dem letzten Leistungspulsintervall der letzten Gruppe der Generator für eine Pause abgeschaltet wird und die Pause so lange gewählt wird dass die an die Teilkathoden abgegebene zeitlich gemittelte Leistung unter Berücksichtigung der Pausen einem vorgegebenen Wert entspricht.

9. HIPIMS-Verfahren welches das Verfahren eines der vorhergehenden Ansprüche umfasst, **dadurch gekennzeichnet, dass** die vorgegebene Leistung des Generators bei mindestens 20kW vorzugsweise bei mindestens 40kW und besonders bevorzugt bei 60kW liegt.

10. HIPIMS-Verfahren nach Anspruch 9, **dadurch gekennzeichnet, dass** die Parameter so gewählt werden dass die an die Teilkathoden abgegebene zeitlich gemittelte Leistung unter 10kW und bevorzugt bei 5kW liegt, wobei die zeitweise und lokal an den Teilkathoden herrschende Entladungsstromdichte vorzugsweise grösser als $0.2A/cm^2$ ist.

**Claims**

1. Method for supplying power impulses with a scalable power impulse interval for operating a PVD sputtering cathode, with the PVD sputtering cathode comprising a first partial cathode and a second partial cathode, wherein for the partial cathodes a maximum average power feed is prescribed and the duration of the power impulse intervals is prescribed, and the method comprises the following steps:

   a) providing a generator with a predefined power output, preferably a power output that is constant at least after switching on and after expiration of a power development interval,
   b) switching on the generator,
   c) connecting the first partial cathode to the generator so that the first partial cathode is fed with power from the generator,
   d) separating the generator from the first partial cathode after expiration of a predefined first power impulse interval corresponding to the first partial cathode,
   e) connecting the second partial cathode to the generator so that the second partial cathode is fed with power from the generator,
   f) separating the generator from the second partial cathode after expiration of a predefined second power impulse interval corresponding to the second partial cathode,

   wherein the first power impulse interval starts time-wise before the second power impulse interval and the first power impulse interval ends time-wise before the second power impulse interval,
   **characterized in that** the steps d) and e) are executed in such a manner that the first power impulse interval and the second power impulse interval overlap in time and all power impulse intervals form together a first group, so that the power output from the generator remains sustained without interruption from the beginning of the first power impulse interval until the end of the second power impulse interval and a second power development interval does not occur.

2. Method according to claim 1, **characterized in that** the overlapping in time of the first power impulse interval and of the second power impulse interval does not constitute more than x% of the power impulse intervals resp. in the case the first power impulse interval differs from the second power impulse interval in terms of its duration, not more than x% of the power impulse interval of the shorter duration, wherein x is smaller than or equal to 20, preferably x is smaller than or equal to 10.

3. Method according to claims 1 or 2, **characterized in that** the PVD sputtering cathode comprises at least a further partial cathode, preferably several further partial cathodes, wherein the further partial cathode can be connected according to steps e) and f) to the generator and can be separated from it, wherein the power impulse interval assigned to the further partial cathode that is next in the sequence overlaps in time with the power impulse interval corresponding to the partial cathode that was immediately before it in the sequence, and wherein the first, second and the further power impulse interval or intervals together form the first group that is not interrupted time-wise, so that the power output from the generator remains sustained during the group interval formed by the first group continuously without interruption and a second power development interval does not occur.

4. Method according to one of the preceding claims, **characterized in that** to the first group a second group is appended, within which the first, second and possibly the further cathodes corresponding to the first group are fed with power impulses within mutually overlapping power impulse intervals, wherein the second group is appended in such a manner to the first group that the first power impulse interval of the second group overlaps with the last power impulse interval of the first group, so that the power output from the generator from the beginning of the first power interval of the first group until the end of the last power interval of the second group remains continuous without interruption and a second power development interval does not occur.

5. Method according to claim 4, **characterized in that** according to the conditions formulated in claim 4 for groups 1 and 2, N groups are attached to one another, wherein N is an integer >1.

6. Method according to claim 5, **characterized in that** the number N of the groups is preferably chosen only so large that for each partial cathode n, it is true that the sum of the power impulse intervals tpn assigned to it minus respectively an overlap tdn over all groups 1 to N does not exceed a maximum time of 100ms.

7. Method according to one of the preceding claims, **characterized in that** during a loss interval, the power delivered by the generator is supplied to a load not used for the coating, wherein the loss interval includes at least the power development interval and the loss interval overlaps with the first power impulse interval of the first group and the loss interval forms together with the groups an uninterrupted sequence.

8. Method according to one of the preceding claims, **characterized in that** the method according to one of the claims is repeated multiple times and that after the last power impulse interval of the last group respectively the generator is switched off for a pause and the pause is chosen to be so long that the power averaged over time delivered to the partial cathodes and taking into account the pauses corresponds to a predefined value.

9. HIPIMS method comprising the method of one of the preceding claims, **characterized in that** the predefined output of the generator is at least 20kW, preferably at least 40kW and even more preferably 60kW.

10. HIPIMS method according to claim 9, **characterized in that** the parameters are chosen in such a way that the power averaged over time delivered to the partial cathodes is below 10kW and preferably at 5kW, wherein the discharge current density that prevails momentarily and locally on the partial cathodes is preferably greater than $0.2A/cm^2$.

**Revendications**

1. Procédé permettant de fournir des impulsions de puissance ayant un intervalle d'impulsion de puissance modulable pour opérer une cathode PVD de pulvérisation, cathode PVD de pulvérisation comprenant une première cathode partielle et une deuxième cathode partielle, dans lequel pour les cathodes partielles une application de puissance moyenne et maximale est prédéterminée et dans lequel la durée des intervalles d'impulsion de puissance est prédéterminée et le procédé comprend les étapes suivantes consistant à :

   a) fournir un générateur ayant une puissance de sortie constante, qui est prédéterminée, préférablement au moins après l'allumage et après l'échéance d'un intervalle de montée en puissance
   b) allumer le générateur
   c) connecter la première cathode partielle au générateur, tel que la puissance à partir du générateur est appliquée à la première cathode partielle
   d) séparer le générateur de la première cathode partielle après l'échéance d'un premier intervalle d'impulsion de puissance prédéterminé correspondant à la première cathode
   e) connecter la deuxième cathode partielle au générateur tel que la puissance à partir du générateur est appliquée à la deuxième cathode partielle
   f) séparer le générateur de la deuxième cathode partielle après l'échéance d'un deuxième intervalle d'impulsion de puissance prédéterminé correspondant à la deuxième cathode

   dans lequel le première intervalle d'impulsion de puissance commence dans le temps avant le deuxième intervalle et le premier intervalle d'impulsion de puissance finit dans le temps avant le deuxième intervalle, **caractérisé par le fait que** les étapes d) et e) sont mises en oeuvre d'une manière que le premier intervalle d'impulsion de puissance et le deuxième intervalle d'impulsion de puissance se chevauchent dans le temps et tous les intervalles d'impulsion de puissance ensemble forment un premier groupe, de sorte que la puissance de sortie à partir du générateur est maintenue constamment sans arrête du début du premier intervalle d'impulsion de puissance jusqu'à la fin du deuxième intervalle d'impulsion de puissance et de sorte qu'il n'y aura pas un deuxième intervalle de montée en puissance.

2. Procédé selon la revendication 1, **caractérisé par le fait que** le chevauchement dans le temps du premier intervalle d'impulsion de puissance et du deuxième intervalle d'impulsion de puissance n'est pas plus de x% des intervalles d'impulsion de puissance, respectivement à condition que ledit premier intervalle d'impulsion de puissance est différent du deuxième intervalle d'impulsion de puissance, n'est pas plus de x% de l'intervalle d'impulsion de puissance à durée plus courte, dans lequel x est inférieur ou égal à 20, préférablement x est égal à 10.

3. Procédé selon les revendications 1 ou 2, **caractérisé par le fait que** la cathode PVD de pulvérisation comprend au moins une cathode partielle additionnelle, préférablement plusieurs cathodes partielles additionnelles, dans lequel les cathodes partielles additionnelles sont connectées au générateur et sont séparée de celui-ci en accord avec les étapes e) et f), dans lequel l'intervalle d'impulsion de puissance assigné à la cathode qui a son tour se chevauche dans le temps avec l'intervalle d'impulsion de puissance correspondant à la cathode qui avait son tour incessamment auparavant, et ledit premier, deuxième et ledit ou lesdits intervalles d'impulsion de puissance additionnelles ensemble forment le premier groupe ininterrompu dans le temps, de sorte que la sortie de puissance à partir du générateur pendant l'intervalle de groupe formé par le premier groupe est maintenue constamment sans arrête et qu'il n'y aura pas un deuxième intervalle de montée en puissance.

4. Procédé selon l'une des revendications précédentes, **caractérisé par le fait qu'**une deuxième groupe est attaché au premier groupe, au sein de laquelle, en accord avec le premier groupe, la première, deuxième et, le cas échéant, les cathodes partielles additionnelles sont chargées avec des impulsions de puissance au sein des intervalles d'impulsion de puissance qui se chevauchent, dans lequel le deuxième groupe est attaché au premier groupe d'une manière que le premier intervalle d'impulsion de puissance du deuxième groupe se chevauche avec le dernier intervalle d'impulsion de puissance du premier groupe, de sorte que la sortie de puissance à partir du générateur du début du premier intervalle de puissance du premier groupe jusqu'à la fin du dernier intervalle de puissance du deuxième groupe reste constamment sans arrête et qu'il n'y aura pas un deuxième intervalle de montée en puissance.

5. Procédé selon la revendication 4, **caractérisé par le fait qu'**en accord avec les conditions formulées selon la revendication 1 pour le groupe 1 et 2, N groupes sont attachés l'un à l'autre, dans lequel N est un nombre entier >1.

6. Procédé selon la revendication 5, **caractérisé par le fait que** le nombre N des groupes est préférablement sélectionné maximalement néanmoins aussi grand, que pour chaque cathode partielle n il vaut que la somme des intervalles d'impulsion de puissance tpn assignée à elle, chacune moins un chevauchement tdn à travers tous groupes 1 à N, ne dépasse pas un temps maximale de 100 ms.

7. Procédé selon l'une des revendications précédentes, **caractérisé par le fait que** pendant un intervalle de perte, la puissance délivrée à partir du générateur est délivrée à une charge qui n'est pas utilisée pour le revêtement, dans lequel l'intervalle de perte au moins comprend l'intervalle de montée en puissance et l'intervalle de montée en puissance chevauche avec le premier intervalle d'impulsion de puissance du premier groupe et l'intervalle de perte ensemble avec les groupes forme un cours ininterrompu.

8. Procédé selon l'une des revendications précédentes, **caractérisé par le fait que** le procédé selon l'une des revendication est répété une pluralité de fois et que le générateur est arrêté pour un temps de pause après le dernier intervalle d'impulsion de puissance du dernier groupe er le temps de pause est sélectionné aussi longtemps, que la puissance moyennée dans le temps et délivré aux cathodes partielles, en tenant compte des temps de pause, corresponde à une valeur prédéterminée.

9. Procédé de HIPIMS comprenant le procédé selon l'une des revendications précédentes, **caractérisé par le fait que** la puissance prédéterminée du générateur est au moins 20 kW, préférablement au moins 40 kW et particulièrement préférablement 60 kW.

10. Procédé de HIPIMS selon la revendication 9, **caractérisé par le fait que** les paramètres sont choisis d'une manière que la puissance moyennée dans le temps et délivré aux cathodes partielles est au-dessous de 10 kW et préférablement est 5 kW, dans lequel la densité de courant de décharge présente aux cathodes partielles par moments et au niveau local est préférablement supérieure à 0,2 A/cm$^2$.

Figur 1:

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011018363

- DE 102006017382 A1